(19) Europäisches Patentamt
European Patent Office
Office européen des brevets

(11) Veröffentlichungsnummer: **0 000 384**
**B1**

(12) # EUROPÄISCHE PATENTSCHRIFT

(45) Veröffentlichungstag der Patentschrift: **30.12.81**

(51) Int. Cl.³: **H 01 L 23/56**

(21) Anmeldenummer: **78100332.2**

(22) Anmeldetag: **07.07.78**

(54) **Anordnung zum Packen schnell schaltender monolitisch integrierter Halbleiterschaltungen, die für die Anschlusspunkte der Stromversorgung des Halbleiterplättchens Entkoppelkondensatoren aufweist, und ein Verfahren zur Herstellung der Anordnung.**

(30) Priorität: **15.07.77 US 815951**

(43) Veröffentlichungstag der Anmeldung: **24.01.79 Patentblatt 79/2**

(45) Bekanntmachung des Hinweises auf die Patenterteilung: **30.12.81 Patentblatt 81/52**

(84) Benannte Vertragsstaaten: **DE FR GB**

(56) Entgegenhaltungen:
**DE-A-1 816 808**
**DE-A-2 523 913**
**GB-A-1 249 108**

(73) Patentinhaber: **International Business Machines Corporation, Armonk, N.Y. 10504 (US)**

(72) Erfinder: **Doo, Ven Young, 5 Saddle Rock Drive, Poughkeepsie, N.Y. 12603 (US)**

(74) Vertreter: **Neuland, Johannes, Dipl.-Ing., Schönaicher Strasse 220, D-7030 Böblingen (DE)**

**EP 0 000 384 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG.

# Anordnung zum Packen schnell schaltender monolithisch integrierter Halbleiterschaltungen, die für die Anschlusspunkte der Stromversorgung des Halbleiterplättchens Entkoppelkondensatoren aufweist, und ein Verfahren zur Herstellung der Anordnung

Die Erfindung bezieht sich auf eine Anordnung zum Packen schnell schaltender monolithisch integrierter Halbleiterschaltungen, die für die Anschlusspunkte der Stromversorgung des Halbleiterplättchens Entkoppelkondensatoren aufweist, und ein Verfahren zur Herstellung der Anordnung.

Monolithisch integrierte Halbleiterschaltungen sind entwickelt worden, um bei höher werdenden Arbeitsgeschwindigkeiten betrieben zu werden. Insbesondere wurden logische Schaltungen für die Anwendung von Computern entwickelt. Die erhöhte Frequenz der Signale der monolithisch integrierten Halbleiterschaltungen hat auch vergleichbare Verbesserungen bezüglich der Struktur der Anordnung zum Packen der monolithisch integrierten Halbleiterschaltungen erfordert. Beispielsweise wird das Übersprechen, das aus der Kopplung zwischen Schaltungen, die den Signalleitungen benachbart sind, herrührt, bei sehr schneller Arbeitsweise wegen der Änderungsgeschwindigkeiten der elektrischen und magnetischen Felder während der Übergangsvorgänge bedeutsam. Dieses Problem wird bei der Benutzung von hochfrequenten Signalen ausgeprägt. Ein anderes bedeutendes Problem stellt das Begrenzen von Spannungsschwankungen in den Stromversorgungsleitungen der Treiberstufen dar, die häufig als Treiberstörspannungen bezeichnet werden. Da der in den Leitungen der Treiberschaltung fliessende Strom verhältnismässig hoch ist, werden die Treiberstörspannungen in erster Linie durch die Induktivität der Leitungen beeinflusst.

Entkoppelkondensatoren sind zur Verringerung der Treiberstörspannungen vorgeschlagen worden. Jedoch sind übliche Entkoppelkondensatoren als diskrete Bauelemente ausgeführt und befinden sich notwendigerweise in einem bestimmten Abstand von der Treiberstufe und erfordern normalerweise zusätzliche Übertragungsleitungen, die die Induktivität erhöhen, wodurch die Wirkung der Entkoppelkondensatoren verringert wird. Gegenwärtig ist die Struktur einer Anordnung zum Packen der monolithisch integrierten Halbleiterschaltungen häufig der begrenzende Faktor, der das vollständige Ausnutzen der besseren Betriebseigenschaften der Halbleiterbauelemente verhindert.

Hier will die Erfindung Abhilfe schaffen. Die Erfindung, wie sie in den Ansprüchen gekennzeichnet ist, löst die Aufgabe, eine Anordnung zum Packen schnell schaltender monolithisch integrierter Halbleiterschaltungen zu schaffen, die für die Anschlusspunkte der Stromversorgung Entkoppelkondensatoren aufweist und bei der aufgrund ihrer Struktur die beim Schalten der Halbleiterbauelemente in den Stromversorgungsleitungen auftretenden Spannungsschwankungen, die Störspannungen darstellen, verringert sind. Ausserdem löst die Erfindung die Aufgabe, ein Verfahren zur Herstellung einer solchen Anordnung anzugeben.

Die Erfindung wird im folgenden durch Beschreibung bevorzugter Ausführungsbeispiele in Verbindung mit den Zeichnungen näher erläutert, von denen zeigen:

Fig. 1 eine Draufsicht auf ein bevorzugtes Ausführungsbeispiel der Anordnung zum Packen monolithisch integrierter Halbleiterschaltungen gemäss der Erfindung, das jedoch ohne ein darauf befestigtes Halbleiterplättchen mit integrierten Schaltungen dargestellt ist;

Die Fig. 2, 3, 4, 5 und 6 eine Reihe von Teil-Schnittansichten, die die Verfahrensschritte erläutern, die erforderlich sind, um den Entkopplungskondensator gemäss dem Verfahren nach der Erfindung innerhalb des Substrates herzustellen;

Fig. 6A ein anderes Ausführungsbeispiel der Erfindung;

Fig. 7 eine Schnittansicht, die die Beziehung einer bevorzugten Ausführungsform des Substrates zu einer darüber befindlichen Masseebene in auseinandergezogener Darstellung wiedergibt;

Fig. 8 eine Seitenansicht, teilweise im Schnitt, die eine bevorzugte Ausführungsform des Substrates und der Masseebene in zusammengebautem Zustand wiedergibt;

Fig. 9 eine Seitenansicht, teilweise im Schnitt, die die Kombination bevorzugter Ausführungsformen des Substrates, der darüber befindlichen Masseebene und einer Kühlplatte in zusammengebautem Zustand darstellt;

Fig. 10 eine Draufsicht auf die Unterseite eines anderen bevorzugten Ausführungsbeispiels einer Masse-Platte gemäss der Erfindung;

Fig. 11 die Ansicht eines längs der Linie 11–11 der Fig. 10 geführten Schnittes und

Fig. 12 die Ansicht eines längs der Linie 12–12 der Fig. 10 geführten Schnittes.

Fig. 1 ist die Draufsicht auf eine bevorzugte Ausführungsform der Anordnung zum Packen monolithisch integrierter Halbleiterschaltungen ohne ein auf ihr befestigtes Halbleiterplättchen dargestellt. Die Anordnung weist ein Substrat 10 aus keramischem Material auf, das vorzugsweise einen Ausdehnungskoeffizienten besitzt, der dem von Silicium sehr nahe kommt. Auf der Oberfläche ist eine grosse Anzahl von Lötflächen in einer Konfiguration angeordnet, die der Konfiguration von Anschlussflächen auf dem aufzulötenden Halbleiterplättchen entspricht. Im allgemeinen dienen die äusseren Reihen 12 und 14 der Lötflächen der Verbindung mit den Signaleingangs-/Ausgangsanschlusspunkten auf dem Halbleiterplättchen. Auf dem Substrat 10 aufgebrachte Leiterzüge 16 und 18, stellen den elektrischen Kontakt mit den Flächen 12 und 14 für die Eingangs-/Ausgangssignale her und über Stifte, die sich durch das Substrat 10 erstrecken, zu einem nicht dargestellten Anschlusspunkt auf der Unterseite.

Die genaue Anzahl der Eingangs-/Ausgangsanschlussflächen und ihre Anordnung ist eine Frage des Entwurfs und kann selbstverständlich gegenüber der dargestellten bevorzugten Ausführungsform variiert werden. Wie noch erläutert wird, ist es jedoch vorzuziehen, dass die Anschlussflächen für die Eingangs-/Ausgangssignale längs der äusseren Peripherie des Halbleiterplättchens angeordnet werden. In dem zentralen Teil des für die Anschlussflächen vorgesehenen Teiles des Substrates 10 sind Anschlussflächen 20 für die Verbindung mit den Anschlusspunkten für die Stromversorgung und das Massepotential des auf dem Substrat zu befestigenden Halbleiterplättchens. Im allgemeinen sind diese Anschlussflächen weiter verstreut als das in Fig. 1 dargestellt ist. Jede der Anschlussflächen 20 ist an eine darunterliegende Durchverbindung angeschlossen, die sich in einem Loch in dem Substrat 10 befindet und mit einem Anschlusspunkt auf der gegenüberliegenden unteren Seite des Substrates verbunden ist. Über dem Durchverbindungsstift, der unter der Anschlussfläche 20 liegt, ist ein Entkopplungskondensator angeordnet, was in der nachfolgenden Beschreibung genauer erläutert wird.

Die erfindungsgemässe Anordnung zum Packen von monolithisch integrierten Halbleiterschaltungen sucht ein bedeutendes Problem, das mit derartigen Anordnungen im allgemeinen verbunden ist, zu mildern, wodurch die Anordnung verträglicher gemacht wird mit heutigen sehr hoch entwickelten Halbleiterschaltungen, insbesondere mit solchen, die zur Durchführung logischer Operationen in schnell arbeitenden Computern entwickelt wurden. Darüber hinaus kann die erfindungsgemässe Anordnung zum Packen monolithisch integrierter Halbleiterschaltungen mit gegenwärtig bekannten Herstellungsverfahren hergestellt werden.

Das erwähnte, bei Anordnungen zum Packen monolithisch integrierter Halbleiterschaltungen auftretende Problem besteht darin, die Treiberstörspannung zu verringern. Das ist die Spannungsänderung in der Treiberschaltung, die durch die Induktivität der Stromversorgungsleitungen und der übrigen Leitungen verursacht wird. Um die Arbeitsgeschwindigkeit eines Computersystems zu erhöhen, ist es sehr erwünscht, dass viele Treiberschaltungen gleichzeitig schalten. Der begrenzende Faktor für die Anzahl der Treiberstufen, die gleichzeitig betrieben werden, ist die Treiberstörspannung. Bei der erfindungsgemässen Anordnung zum Packen monolithisch integrierter Halbleiterschaltungen sind Entkoppelkondensatoren in unmittelbarer Nachbarschaft der Anschlüsse für die Stromversorgung vorgesehen. Für die Treiberstörspannung V gilt die Beziehung:

$$V = -nL\frac{dI}{dt},$$

in der n die Anzahl der während des Zeitintervalles dt gleichzeitig schaltenden Treiberstufen ist, L die Induktivität und $\frac{dI}{dt}$ die zeitliche Änderung des Stromes während des Schaltens ist. Der Wert von $\frac{dI}{dt}$ ist festgelegt durch die Betriebsparameter der monolithisch integrierten Halbleiterschaltung und kann nicht wesentlich geändert werden. Die Induktivität L ist jedoch eine Variable, die, wenn sie verringert wird, auch die Treiberstörspannung gemäss der oben angegebenen Beziehung verringert. Von Interesse ist jedoch die folgende Grössengleichung

$$V^2 = \frac{1}{CL},$$

in der V die Lichtgeschwindigkeit, L die Induktivität und C die Kapazität bedeuten. Wie die Beziehung zeigt, ist das Produkt C × L eine Konstante. Wenn daher C grösser gemacht wird, dann wird L kleiner, was erwünscht ist. Daher kann die Treiberstörspannung kleiner gemacht werden durch Vergrössern der Kapazität der Stromversorgungsleitungen. Diese Kapazität kann vergrössert werden durch die Verwendung von Entkoppelungskondensatoren, die den Leiterzügen der Anordnung zum Packen monolithisch integrierter Halbleiterschaltungen zugeordnet sind. Ein weiteres in hochentwickelten Strukturen zum Packen monolithisch integrierter Halbleiterschaltungen auftretendes Problem, das durch die besondere Ausführungsart der Erfindung gemildert wird, ist die Signalverzögerung. Die Arbeitsgeschwindigkeit monolithisch hochintegrierter Schaltungen wird zu einem grossen Teil begrenzt durch die durch die Anordnung zum Packen der Schaltungen bedingte Übertragungsverzögerung. Das ist deshalb der Fall, weil die Schaltverzögerung der aktiven Schaltelemente verhältnismässig unbedeutend wird im Hinblick auf die Ausbreitungsverzögerung in der Anordnung zum Packen der monolithisch hochintegrierten Halbleiterschaltungen. Die Ausbreitungsverzögerung beruht zu einem grossen Teil auf der grossen Dielektrizitätskonstante des isolierenden Materials zwischen den Schichten einer üblichen Anordnung zum Packen der monolithisch integrierten Halbleiterschaltungen. Die Dielektrizitätskonstante von isolierendem Material ist grösser als Eins. Die Dielektrizitätskonstante von keramischem Material beträgt etwa Neun. Je grösser die Dielektrizitätskonstante ist, um so geringer ist die Signalausbreitungsgeschwindigkeit. Bei der Anordnung nach der Erfindung wird teilweise eine Luftisolation für das Isolieren der Leiterzüge benutzt. Ein drittes Problem, das mit üblichen Anordnungen zum Packen monolithisch integrierter Halbleiterschaltungen verbunden ist, ist das Übersprechen zwischen den Signalleitungen. Das Übersprechen wird zwischen im allgemeinen parallel verlaufenden Signalleitungen durch die induktive und kapazitive Kopplung der Leitungen verursacht. Durch eine besondere Ausführungsart der Erfindung ist in unmittelbarer Nachbarschaft zu den Signalleitungen und über ihnen eine mit dem Bezugspotential verbundene Metallplatte angeordnet, um die

kapazitive Kopplung benachbarter Leitungen zu verringern.

In den Fig. 2 bis 9 ist ein bevorzugtes Verfahren zur Herstellung der Anordnung zum Packen von monolithisch integrierten Halbleiterschaltungen erläutert. Ein Substrat 10 wird aus einem isolierenden Material geformt, vorzugsweise aus einem Material, das einen Wärmeausdehnungskoeffizienten besitzt, der im wesentlichen dem Wärmeausdehnungskoeffizienten von Silicium entspricht. Keramik und Glaskeramik sind die üblichen für diesen Zweck geeigneten Materialien. Die Dicke des Substrates 10 liegt vorzugsweise in der Grössenordnung von 0,5 bis 1,5 mm. Es sind Löcher 22 vorgesehen, die vorzugsweise kegelförmig ausgebildet sind, wie das dargestellt ist. Im allgemeinen weisen die Löcher 22 einen Durchmesser von 75 bis 150 $\mu$ am schmaleren und einen von 250 bis 500 $\mu$ am grösseren Ende auf. Das mit Löchern versehene Substrat kann in jeder geeigneten Weise hergestellt werden. Wenn ein keramisches Material verwendet wird, kann ein Keramikschlamm, der ein feinverteiltes keramisches Material und ein Bindemittel enthält, mit einem Abstreifmesser auf die gewünschte Dicke gebracht werden. Es werden die Löcher gestanzt oder geformt und das erhaltene Blatt aus ungebranntem keramischem Material wird gesintert. Alternativ kann das Substrat auch gepresst und gesintert werden, wenn das erwünscht ist.

In dem Substrat 10 sind die Löcher 22 so gebildet, dass ihre Konfiguration unter den Anschlussflächen 20 des Halbleiterplättchens liegt, die ihm die elektrische Energie zuführen, wie das in Fig. 1 dargestellt ist. Das Substrat 10 kann in jeder geeigneten Grösse hergestellt werden und jede passende Anzahl von Halbleiterplättchen aufnehmen. Im allgemeinen ist es jedoch schwierig, mehr als drei Halbleiterplättchen auf einem Substrat unterzubringen, wenn nur eine Metallisierungsebene verwendet wird. Die Konfiguration der Löcher 22 muss vor dem Stanzen entworfen werden und das Schrumpfen des Substrates beim Sintern berücksichtigen. Daher muss das Ausgangsmuster in dem ungesinterten Substrat um den Betrag, um den das Substrat während des Sinterns schrumpft, grösser sein als das Muster auf dem Halbleiterplättchen. Wie das in Fig. 3 gezeigt ist, ist das Substrat mit einer Photolackschicht 24 auf derjenigen Oberfläche maskiert, auf der die Löcher den grösseren Durchmesser aufweisen.

Der Photolack wird belichtet und entwickelt, um eine Öffnung 25 über den Löchern zurückzulassen, in der die Entkoppelkondensatoren gebildet werden. Im allgemeinen liegen diese Öffnungen unter den Anschlüssen für die Stromversorgung und das Massepotential des Halbleiterplättchens nach dessen Aufbringen. Die Schicht 24 bedeckt daher Öffnungen 22, die als einfache Durchverbindungslöcher für die Signalleitungen dienen. Eine dünne Schicht 26 eines Basismetalles und eine Schicht 27 innerhalb der Löcher, wird dann auf dem nicht von der Maske 24 bedeckten Substrat abgeschieden. Als Basismetall dient vorzugsweise entweder Aluminium, Titan, Tantal oder Kupfer, das bis zu einer Dicke in der Grössenordnung von einigen Mikrometern abgeschieden wird. Das Abscheiden von Metall kann erreicht werden durch Aufdampfverfahren, Abscheiden durch Zerstäuben oder durch stromlose Metallabscheidung. Wenn das Metall der Schichten 26 und 27 durch Aufdampfen oder durch Zerstäuben aufgebracht wird, wird der Film, der sich auf der Oberfläche des Photolackes 24 abscheidet zusammen mit dieser Schicht entfernt. Die Dicke der Schichten 26 und 27 kann, wenn das erwünscht ist, durch Galvanisieren verstärkt werden. Dieses Verfahren ist bekannt und wird im allgemeinen so ausgeführt, dass die leitenden Schichten 26 und 27 die Kathode in einem galvanischen Bad bilden. Nach dem Entfernen der Maske 24, werden die verstärkten Schichten 26 und 27 eloxiert, um eine dünne dielektrische Schicht 28 zu bilden, die vorzugsweise eine Dicke im Bereich von 0,25 bis zu einigen Nanometern aufweist, wie das in Fig. 4 angedeutet ist. Diese dielektrische Schicht 28 wird durch Eloxieren der Metallschicht in einer geeigneten Lösung gebildet. Das so gebildete Oxid hängt ab von der Beschaffenheit der Ausgangsschicht. Wenn die Schichten 26 und 27 aus Aluminium bestehen, wird $Al_2O_3$ gebildet, wenn die Anfangsschichten aus Titan bestehen, wird $TiO_2$ gebildet und wenn sie aus Tantal bestehen, so wird $Ta_2O_5$ gebildet. Das eloxierte Substrat kann dann in einer oxidierenden Atmosphäre erhitzt werden, um das Metall zu oxidieren, das durch das Eloxierverfahren nicht gut bedeckt wurde infolge des Vorhandenseins von feinen Löchern in dem eloxierten Oxid. Wenn das Basismetall Kupfer ist, wird eine dünne Oxidschicht wie z.B. $SiO_2$, $Al_2O_3$ usw. auf dem Kupfer durch Zerstäuben oder in anderer Weise abgeschieden. Wie das in Fig. 5 angedeutet ist, wird eine Maske 30, die eine verhältnismässig grosse Dicke in dem Bereich von 75 bis 150 Mikrometer besitzt, auf einer Oberfläche des Substrates 10 gebildet. Die Maske 30 kann durch Vorstanzen einer Kunststoffolie gebildet werden, die Öffnungen 31 mit einem grösseren Durchmesser aufweist als die freiliegenden Öffnungen der Löcher 22. Die maskierende Folie 30 wird auf der Oberfläche des Substrates 10 befestigt und die Öffnungen mit einer elektrisch leitenden Paste gefüllt, die vorzugsweise aus Kupfer mit 3 bis 6% Zink und/oder Zinn in Kombination mit einem geeigneten Träger besteht. Die Paste kann in die Öffnungen 22 und die Öffnungen 31 der Maske gedrückt werden. Wenn das erwünscht ist, können die Löcher 22 vor dem Anwenden der Maske 30 getrennt gefüllt werden. Alternativ können die Löcher 22 und 31 chemisch metallisiert werden.

Um Kontakt mit der Metallschicht 26 herzustellen, kann zumindest eines der Löcher 22 vor dem Eloxieren maskiert werden. Das Loch kann maskiert werden durch Bilden einer Photolackschicht über der Öffnung oder durch ihre Abdeckung mit Paraffin. Während des Eloxierens wird die innere Fläche des maskierten Loches nicht eloxiert.

Wenn anschliessend die leitende Paste eingebracht wird, wie das in Fig. 5 dargestellt ist, steht der so gebildete leitende Kegel 41 in direktem Kontakt mit der leitenden Schicht 27. In all den restlichen Löchern, in denen Entkoppelkondensatoren gebildet werden, ist der aus leitender Paste in den Löchern gebildete Kegel von der leitenden Schicht 27 durch die eloxierte Schicht 28 getrennt, die aus einem dielektrischen Material besteht. Die nach dem Entfernen der maskierenden Schicht 30 erhaltene Struktur ist, wie in Fig. 6 angedeutet, eine Reihe von Kondensatoren, bei denen der leitende Kegel 40 die eine Elektrode, die leitende Schicht 27 die andere Elektrode ist und die dielektrische Schicht 28 aus der eloxierten Schicht oder dem niedergeschlagenen Oxid 26 gebildet wird. Der in direktem Kontakt mit der Schicht 27 stehende Kegel 41 bildet den Masseanschluss für die Schicht 26, die alle Schichten 27 der Entkoppelkondensatoren untereinander verbindet. Nach Fig. 6 ist auf der gegenüberliegenden Seite des Substrates 10 ein Metallisierungsmuster aus den Streifen 16 und 18 gebildet, das, wie das in Fig. 1 dargestellt ist, die Signalanschlüsse des auf das Substrat aufzubringenden Halbleiterplättchens mit den Durchverbindungen 38 verbindet, die nicht unter dem Halbleiterplättchen liegen. Dieses Metallisierungsmuster kann in irgendeiner geeigneten Art gebildet werden, z.B. durch Befestigen einer gelochten Maskierungsschicht an der Oberfläche des Substrates, Bilden der Öffnungen für die Metallisierungsstreifen durch Schneiden mit einem Elektronenstrahl und anschliessendes Füllen der Öffnungen mit einer leitenden Paste. Alternativ kann eine metallische Deckschicht aufgebracht werden und ein geeignetes Muster durch subtraktives Ätzen erzeugt werden, was bekannt ist. Ein anderes alternatives Verfahren besteht im Abschneiden einer dünnen Metallschicht (0,1 nm), Bilden eines dem Muster der Signalleitungen entsprechenden Fensters aus Photolack, anschliessend galvanische Metallabscheidung in dem Fenster, Entfernen des Photolacks und schliesslich Tauchätzen, um die anfängliche dünne Metallbelegung längs der Leitungen zu entfernen und sie dadurch elektrisch voneinander zu trennen.

Nachdem das Metall und der Träger durch Siebdruck in die Durchverbindungslöcher 22 gebracht wurden, folgt das Sintern, was zum Verbrennen des Trägers und zum Zusammenbacken der Teilchen zu einer einzigen festen Masse führt. Wie in Fig. 6 dargestellt, weist die erhaltene Struktur eine Reihe von Signalanschlüssen 39 und eine Reihe von Stromversorgungsanschlüssen 43 auf, denen ein Entkoppelkondensator zugeordnet ist, der in unmittelbarer Nachbarschaft zu den Stromversorgungsanschlüssen des Halbleiterplättchens angeordnet ist. In Fig. 6A ist eine andere Struktur dargestellt, die auf andere Weise hergestellt wurde. Bei diesem Ausführungsbeispiel ist das Substrat 10A mit zylindrischen Löchern 22A versehen, die in der gleichen grundsätzlichen Konfiguration angeordnet sind, die in Verbindung mit Fig. 2 erläutert wurde. Eine maskierende Photolackschicht, die mit der in Fig. 3 dargestellten Schicht 24 gleichartig ist, wird abgeschieden, belichtet und entwickelt, um den Bereich freizulegen, der die Durchverbindungslöcher für das Zuführen der Versorgungsspannungen und des Massepotentials umgibt. Eine Metallschicht 27A wird dann in dem freigelegten Bereich durch irgend ein geeignetes Verfahren abgeschieden. Diese Schicht 27A braucht sich nicht auf die Wandungen 22A der Durchverbindungslöcher erstrecken, obwohl sie dort vorgesehen werden kann, wenn das erwünscht ist. Nach dem Entfernen der Photolackschicht werden Koaxialkabelstücke 40A in die Durchverbindungslöcher zur Zuführung der Stromversorgungsspannung eingefügt, deren Enden 43A sich über die Oberfläche hinaus erstrecken und dadurch Anschlüsse für die Befestigung auf einer tragenden Karte oder einer anderen Struktur bilden. Die oberen Enden der Koaxialkabelstücke 40A werden von der Isolierschicht 28A befreit. Die äussere Metallschicht 27A des Koaxialkabels bildet einen elektrischen Kontakt mit der Schicht 26A. Die isolierende Schicht 28A isoliert das Koaxialkabelstück 40A elektrisch von dessen äusserer Metallschicht 27A und bildet dadurch einen Entkopplungskondensator. Ein Drahtstück 41A ist in das Loch 22A eingesetzt und bildet den Anschluss 45A der Entkoppelkondensatoren, der mit dem Massepotential verbunden ist. Gleiche Stücke 38A sind in die Signal-Durchverbindungslöcher eingesetzt und bilden dadurch die Signalanschlüsse 39A. Die Seite für die Aufnahme des Halbleiterplättchens wird eben gehalten, erforderlichenfalls durch Abschleifen. Eine dielektrische Deckschicht 42A wird über der Seite gebildet, die zur Aufnahme des Halbleiterplättchens bestimmt ist und es werden Löcher in die Deckschicht geätzt an den Stellen, wo sich die Drahtstücke 38A, 41A und 40A befinden. Es muss besondere Sorgfalt aufgewandt werden, um sicherzustellen, dass das Loch über dem Innenleiter 40A des Koaxialkabelstückes sich nicht bis zu der dielektrischen Schicht 28A erstreckt. Eine mehrschichtige metallische Deckschicht wie beispielsweise Cr–Cu–Cr wird durch irgend ein geeignetes Verfahren aufgebracht und die Metallisierungsmuster 16A und 18A sowie Kontaktflächen 20A durch übliches subtraktives Ätzen erzeugt. Dieses Substrat kann in der gleichen Weise weiterverarbeitet werden, wie das für das erste in Fig. 6 dargestellte Ausführungsbeispiel beschrieben wurde.

Wie das in Fig. 7 angegeben ist, können zwischen den Leiterzügen 16 und 18 Aussparungen gebildet werden, die die kapazitive Kopplung durch Vergrössern der Menge an Luftdielektrikum verringern. Die Aussparungen 30 können mit einem Elektronenstrahl oder mit einer Nasssäge geschnitten werden und sind vorzugsweise 25 bis 35 Mikrometer tief. Wenn Glaskeramik als Substrat 10 verwendet wird, können die Aussparungen durch Ätzen gebildet werden, wobei die Metallfläche als Ätzmaske dient.

Der Querschnitt des Substrates in dieser Stufe

des Verfahrens ist in Fig. 7 dargestellt. Ein Siliciumplättchen 34 mit monolithisch integrierten Schaltungen ist auf die Lötflächen 20 und die Anschlussflächen 12 und 14 der Metallisierung für die Signale aufgelötet. Die Anschlüsse 43, die einen Teil der Treiberschaltung bilden, und die Anschlüsse 39, die einen Teil der Metallisierung für die Signale bilden, sind mit Anschlüssen auf einer geeigneten Schaltkarte oder einem anderen Träger verbunden. Der Anschluss 45, der in Kontakt mit der leitenden Schicht 27 ist, die eine gemeinsame Ebene für alle Entkoppelkondensatoren bildet, ist mit dem Massepotential verbunden.

Um die induktiven und kapazitiven Kopplungen zwischen den Signalleitungen der streifenförmigen Signalmetallisierung auf der Oberfläche des Substrates 10 zu verringern, ist eine darüber angeordnete Masseebene 50 vorgesehen, die sich dicht über der streifenförmigen Metallisierung für die Signalleitungen 16 und 18 befindet. Die Masseebene 50 weist eine Öffnung 51 zur Aufnahme des Halbleiterplättchens 34 auf und ist mit Abstandshaltern 52 aus Isoliermaterial versehen, die die Oberfläche des Substrates oder die streifenförmige Metallisierung berühren und dadurch einen bestimmten Abstand aufrechterhalten. Die Abstandshalter 52 aus Isoliermaterial können alternativ auch auf dem Substrat vorgesehen werden. In Fig. 8 ist das Substrat 10 mit der über ihm angeordneten Masseebene 50 dargestellt.

Die Masseebene 50 ist an das Massepotential durch geeignete elektrische Verbindungen angeschlossen. Nach Fig. 9 ist eine Wasserkühlungs-Platte 60 mit einem vorzugsweise serpentinenartigen Wasserweg an dem Modul befestigt. Die Wasserkühlungs-Platte 60 kann mit der Masseebene 50 verbunden sein oder alternativ kann die Masseebene ein integraler Bestandteil der Wasserkühlungs-Platte sein. Der zentrale Bereich der Wasserkühlungs-Platte über dem Halbleiterplättchen 34 ist an diesen mit einem gut wärmeleitenden, elektrisch isolierenden pastenartigen Material 62 befestigt, um die Wärmeabfuhr von dem Halbleiterplättchen 34 zu der Wasserkühlungs-Platte 60 zu verbessern.

Das wärmeleitende pastenartige Material leitet die Wärme von dem Halbleiterplättchen zu der Wasserkühlungs-Platte und dient als Puffer für die Wärmeausdehnung und das Zusammenziehen des Halbleiterplättchens, wodurch Wärmespannungen in dem Halbleiterplättchen 34 vermieden werden. Der Einlass 64 und der Auslass 66 können mit irgendeiner geeigneten Wasserquelle zwecks Zirkulation des Wassers verbunden werden.

Der das Halbleiterplättchen umgebende Raum kann in einfacher und wirksamer Weise durch eine Dichtung 52 zwischen dem Flansch 50 und dem Substrat 10 und einer zweiten Dichtung 53 zwischen der Wasserkühlungs-Platte 60 und der Masseebene 50 abgedichtet werden. Die Dichtungen 52 und 53 können aus irgendeinem geeigneten Material gebildet werden, z.B. aus einem organischen Harzmaterial oder einem niedrigschmelzenden Lot.

In den Fig. 10–12 ist eine andere bevorzugte Ausführungsform für die Masseebene dargestellt. Bei dieser Ausführungsform ist die Masseebene 70 in eine Reihe von Abschnitten unterteilt. Wie aus Fig. 11 ersichtlich, sind auf der das Substrat bildenden Metallplatte 70, die ein Loch 71 aufweist, das dem Halbleiterplättchen entspricht, auf der oberen und unteren Hauptfläche Isolierschichten 72 und 74 aufgebracht. Metallschichten 76 und 78 sind über den isolierenden Schichten 72 und 74 auf den Abschnitten aufgebracht. Ein Wasseranschluss 80 ist in dem Raum zwischen den Quadranten der Metallschicht 78 vorgesehen und erstreckt sich durch die dielektrische Schicht 74 bis zu dem metallischen Substrat 70. Anschlussflächen 82 sind auf der Metallschicht 78 in direktem elektrischem Kontakt mit ihr gebildet. Wenn die Masseebene 70 auf das Substrat 10 gelegt wird, wie das in der Draufsicht nach Fig. 1 dargestellt ist, werden die Anschlussflächen 80 mit den Anschlussflächen 81 auf dem Substrat und die mit der Metallschicht 78 verbundenen Anschlussflächen 82 mit den Anschlussflächen 83 auf dem Substrat 10 verbunden.

**Patentansprüche**

1. Anordnung zum Packen schnell schaltender monolithisch integrierter Halbleiterschaltungen, die Entkoppelkondensatoren für die Stromversorgungsleitungen des Halbleiterplättchens aufweist, dadurch gekennzeichnet, dass die Entkoppelkondensatoren sich in den für die Zufuhr der Versorgungsspannung zum Halbleiterplättchen vorgesehenen Löchern einer das Halbleiterplättchen aufnehmenden Substratplatte aus elektrisch isolierendem Material befinden und die Versorgungsspannung dem Halbleiterplättchen über eine erste Elektrode eines Entkoppelkondensators zugeführt wird.

2. Anordnung nach Anspruch 1, dadurch gekennzeichnet, dass die zweiten Elektroden aller Entkoppelkondensatoren der Substratplatte untereinander und mit dem Bezugspotential verbunden sind.

3. Verfahren zur Herstellung einer Anordnung nach den Ansprüchen 1 und 2, dadurch gekennzeichnet, dass

a) auf der mit Löchern versehenen Substratplatte aus elektrisch isolierendem Material eine Maske (24; Fig. 3) aufgebracht wird, die nur diejenigen Löcher und deren unmittelbare Umgebung nicht bedeckt, die für die Zufuhr der Versorgungsspannung zum Halbleiterplättchen vorgesehen sind,

b) in den genannten Löchern und ihrer unmittelbaren Umgebung eine dünne Schicht (26, 27; Fig. 3) eines der Metalle Aluminium, Tantal oder Titan abgeschieden wird,

c) die abgeschiedene dünne Metallschicht durch Galvanisieren verstärkt wird,

d) die Maske entfernt und die Metallschicht zur Bildung einer über ihr befindlichen dielektrischen Schicht (28; Fig. 4) teilweise eloxiert wird,

e) die Löcher der Substratplatte mit Metall gefüllt und

f) die Substratplatte mit Leiterzügen versehen wird, die das Metall in den Löchern kontaktieren.

4. Verfahren nach Anspruch 3, dadurch gekennzeichnet, dass die im Schritt b) abgeschiedene dünne Metallschicht chemisch abgeschieden wird.

5. Verfahren nach Anspruch 3, dadurch gekennzeichnet, dass die im Schritt b) abgeschiedene dünne Metallschicht im Vakuum abgeschieden wird.

6. Verfahren nach Anspruch 3, dadurch gekennzeichnet, dass die Löcher der Substratplatte dadurch mit Metall gefüllt werden, dass eine Paste aus feinverteilten Metallteilchen und einem organischen Bindemittel im Siebdruckverfahren in die Löcher eingebracht wird.

7. Verfahren nach Anspruch 6, dadurch gekennzeichnet, dass eine vorgelochte Maske auf dem Substrat so befestigt wird, dass ihre Löcher, deren Durchmesser grösser als der der Löcher des Substrates ist, konzentrisch zu diesen angeordnet sind, dass die Paste in die Löcher der Maske und des Substrates gebracht, die Maske entfernt und die Paste gesintert wird.

8. Verfahren nach Anspruch 3, dadurch gekennzeichnet, dass die Leiterzüge des Substrates gebildet werden durch

a) Abscheiden einer metallischen Deckschicht auf dem Substrat,

b) Aufbringen, Belichten und Entwickeln einer Photolackschicht, die das gewünschte Leiterzugsmuster definiert und

c) Abätzen des nicht benötigten Metalles.

9. Verfahren nach Anspruch 3, dadurch gekennzeichnet, dass das Leiterzugsmuster gebildet wird durch

a) Aufbringen einer Metallmaske mit Öffnungen, die dem gewünschten Leiterzugsmuster entsprechen, auf das Substrat und

b) Füllen der Maskenöffnungen mit einer elektrisch leitenden Paste im Siebdruckverfahren.

10. Verfahren zum Herstellen einer Anordnung nach den Ansprüchen 1 und 2, dadurch gekennzeichnet, dass die Entkoppelkondensatoren durch Einsetzen von Koaxialkabelstückchen in die Löcher des aus elektrisch isolierendem Material bestehenden Substrates gebildet werden.

**Claims**

1. Array for packaging high-speed monolithic integrated semi-conductor circuits comprising decoupling capacitors for the power input device lines, characterized in that the decoupling capacitors are located in holes of a substrate board provided for the semi-conductor chip voltage supply, the substrate board comprising electrically insulating material and receiving the semiconductor chip, and in that the voltage supply is fed to the semiconductor chip via the first electrode of a decoupling capacitor.

2. Array as in claim 1, characterized in that the second electrodes of all the decoupling capacitors on the substrate board are interconnected to each other and to a potential reference.

3. Process for forming an array according to claims 1 and 2, characterized by the following steps:

a) depositing a mask (24; Fig. 3) on the substrate board containing holes, leaving exposed only the holes and their immediate surroundings that are provided for the voltage supply to the semiconductor chip,

b) depositing a thin layer (26, 27; Fig. 3) of one of the metals Al, Ta or Ti in the holes and on their immediate surroundings,

c) building up the deposited thin metal layer by electroplating,

d) removing the mask and partially anodizing the metal layer to thereby form and overlying dielectric layer (28; Fig. 4),

e) filling the holes in the substrate board with metal and

f) forming a conductor pattern on the substrate board to contact the metal in the holes.

4. Process as in claim 3, characterized by the chemical deposition of the thin metal layer in step b).

5. Process as in claim 3, characterized by the vacuum deposition of the thin metal layer in step b).

6. The process of claim 3, characterized in that the holes in the substrate board are filled with a metal by forming a paste of finely distributed metal particles and an organic vehicle and forcing this paste into the holes by squeege printing.

7. The process of claim 3, characterized in that a pre-punched mask is mounted on the substrate in such a way that the holes in the mask having a larger diameter than the holes in the substrate are concentrically registered with the latter ones, that the paste is introduced into the holes in the mask and the substrate and that finally the mask is removed and the paste is sintered.

8. Process as in claim 3, characterized in that the conductor patterns on the substrate are formed in subsequent steps:

a) deposition of a metallic covering layer on the substrate,

b) deposition, exposure and development of a photo-resist layer to define the desired conductor pattern and

c) etching off the unneeded metal.

9. Process as in claim 3, characterized in that conductor pattern is formed by

a) the deposition of a metal mask having openings corresponding to the desired conductor pattern on the substrate and

b) filling the mask holes with an electrically conducting paste in a squeege printing procedure.

10. Process for forming an array according to claims 1 and 2, characterized in that the decoupling capacitors are formed by inserting lengths of coax cables into the holes of the substrate consisting of an electrically isolating material.

**Revendications**

1. Dispositif pour monter des circuits semiconducteurs monolithiquement intégrés à vitesse élevée comportant des condensateurs de découplage pour les lignes d'alimentation de la microplaquette semiconductrice, caractérisé en ce que les condensateurs de découplage sont placés dans les trous d'un substrat de matériau électriquement isolant recevant la microplaquette semi-conductrice, lesdits trous étant destinés à amener la tension d'alimentation à la microplaquette semi-conductrice, et en ce que la tension d'alimentation est appliqué à la microplaquette semiconductrice à travers la première électrode d'un condensateur de découplage.

2. Dispositif selon la revendication 1, caractérisé en ce que les secondes électrodes de tous les condensateurs de découplage du substrat sont connectées entre elles et avec le potentiel de référence.

3. Procédé pour fabriquer un dispositif selon l'une des revendications 1 et 2, caractérisé en ce que l'on:

a) dépose, sur le substrat d'un matériau électriquement isolant comportant des trous, un masque (24; figure 3) qui ne recouvre pas ceux des trous et leur environnement immédiat qui sont destinés à amener la tension d'alimentation à la microplaquette semi-conductrice,

b) dépose dans lesdits trous et leur environnement immédiat une couche mince (26, 27; figure 3) d'un des métaux: aluminium, tantale ou titane,

c) renforce, par galvanisation, la couche de métal mince déposée,

d) enlève le masque et on oxyde anodiquement une partie de la couche métallique pour former une couche diélectrique superposée sur cette couche (28; figure 4),

e) remplit les trous du substrat avec du métal, et

f) forme sur le substrat des conducteurs qui établissent un contact avec le métal situé dans les trous.

4. Procédé selon la revendication 3, caractérisé en ce que la couche métallique mince déposée dans l'étape b) est déposée chimiquement.

5. Procédé selon la revendication 3, caractérisé en ce que la couche métallique mince déposée dans l'étape b) est déposée sous vide.

6. Procédé selon la revendication 3, caractérisé en ce que les trous réalisés dans le substrat sont remplis de métal en étalant dans les trous une pâte de particules métalliques finement dispersées et d'un liant organique à l'aide de la technique d'impression par écran.

7. Procédé selon la revendication 6, caractérisé en ce que l'on fixe un masque préperforé sur le substrat de telle sorte que les trous du masque dont le diamètre est supérieur à celui des trous du substrat sont disposés concentriquement par rapport à ces derniers, et en ce que l'on étale la pâte dans les trous du masque et du substrat, on enlève le masque et on fritte la pâte.

8. Procédé selon la revendication 3, caractérisé en ce que les conducteurs du substrat sont formés par:

a) dépôt d'une couche métallique de recouvrement sur le substrat,

b) dépôt, exposition et développement d'une couche de résine photosensible définissant la configuration de conducteurs désirée, et

c) décapage du métal en excés.

9. Procédé selon la revendication 3, caractérisé en ce que la configuration de conducteurs est formée par:

a) dépôt, sur le substrat, d'un masque métallique comportant des ouvertures qui correspondent à la configuration de conducteur désirée, et

b) remplissage des ouvertures du masque avec une pâte électriquement conductrice à l'aide de la technique d'impression par écran.

10. Procédé pour fabriquer un dispositif selon l'une quelconque des revendications 1 et 2, caractérisé en ce que l'on forme les condensateurs de découplage en insérant des parties de câble coaxial dans les trous du substrat d'un matériau électriquement isolant.

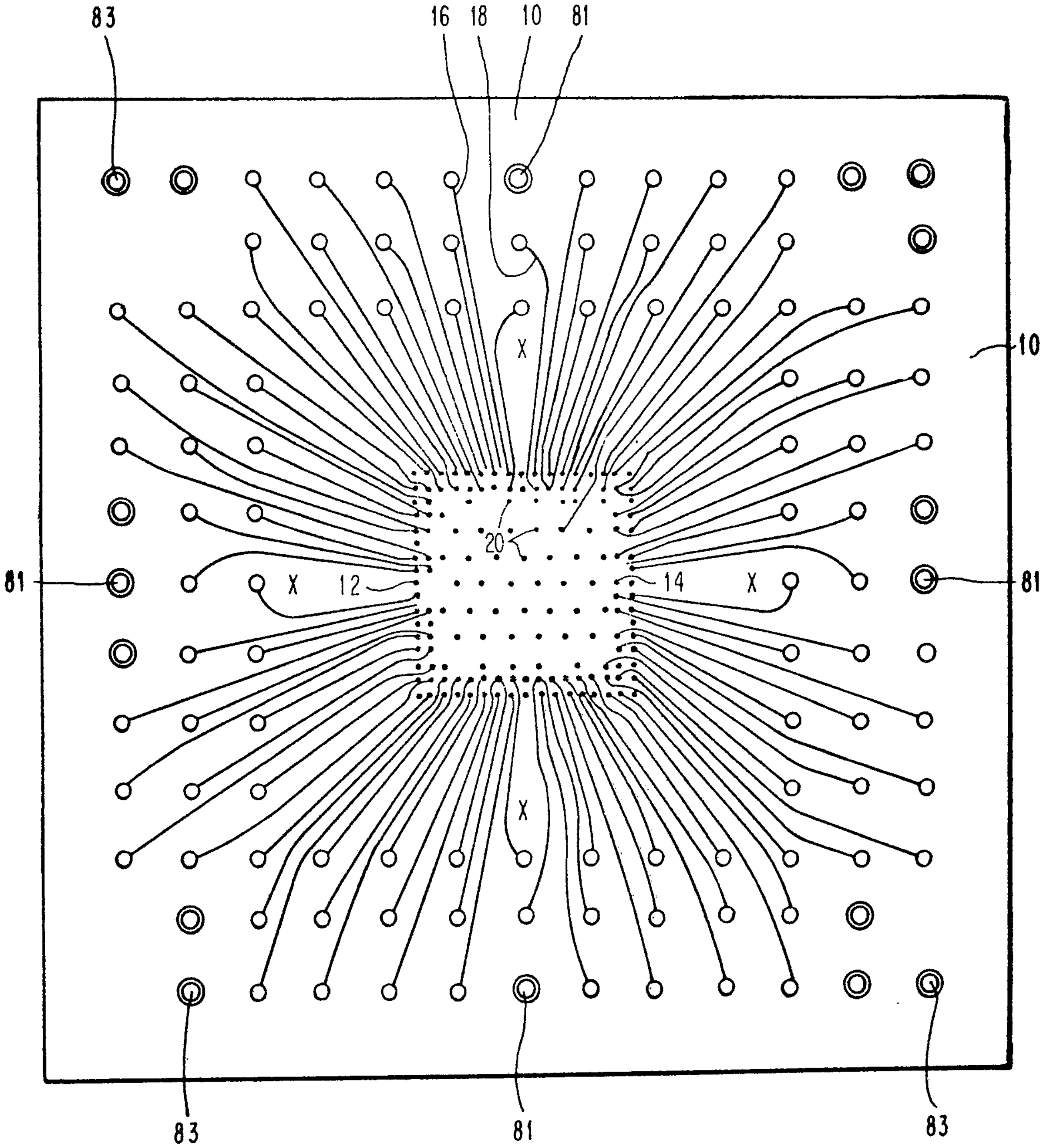


FIG. 1

FIG. 2

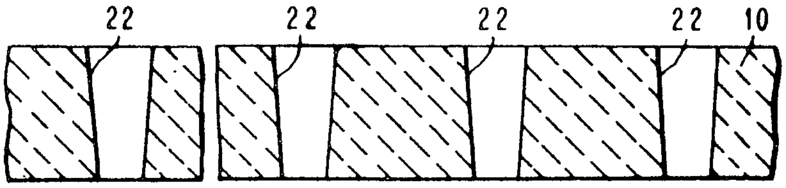


FIG. 3

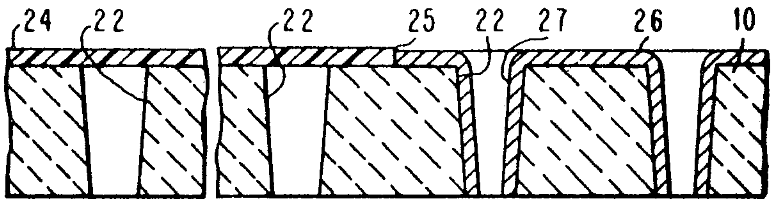


FIG. 4

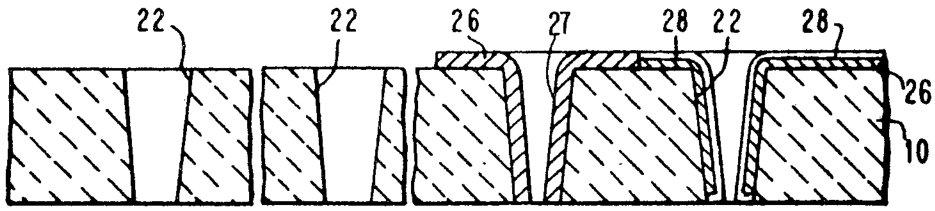


FIG. 5

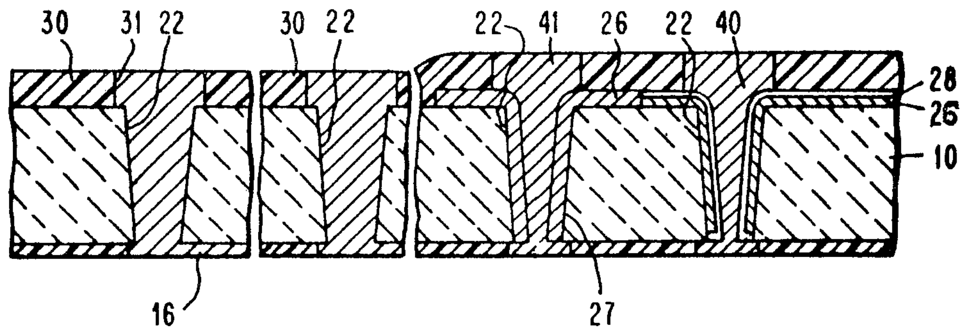


FIG. 6

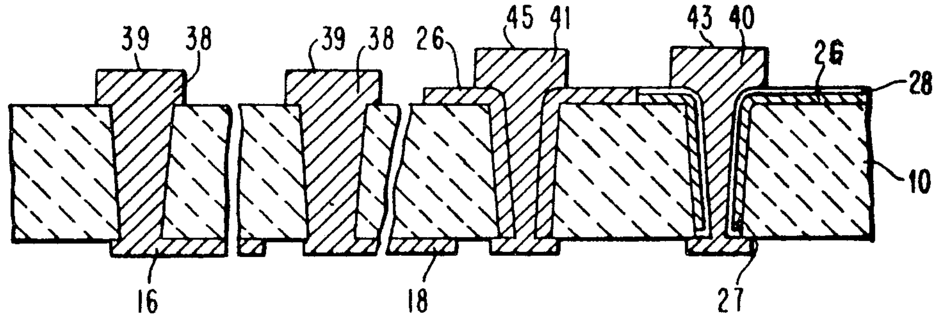


FIG. 6A

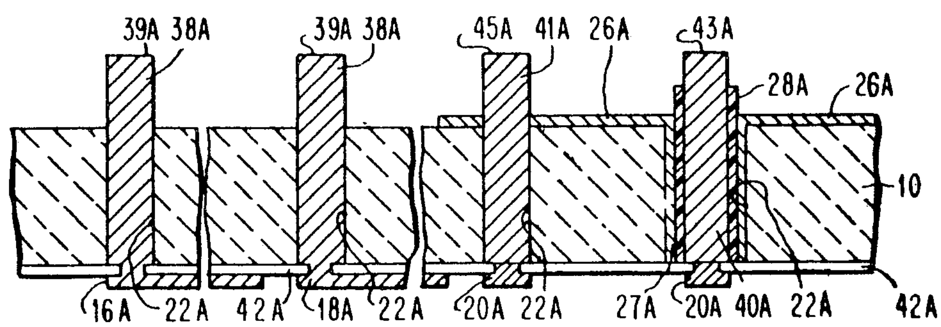

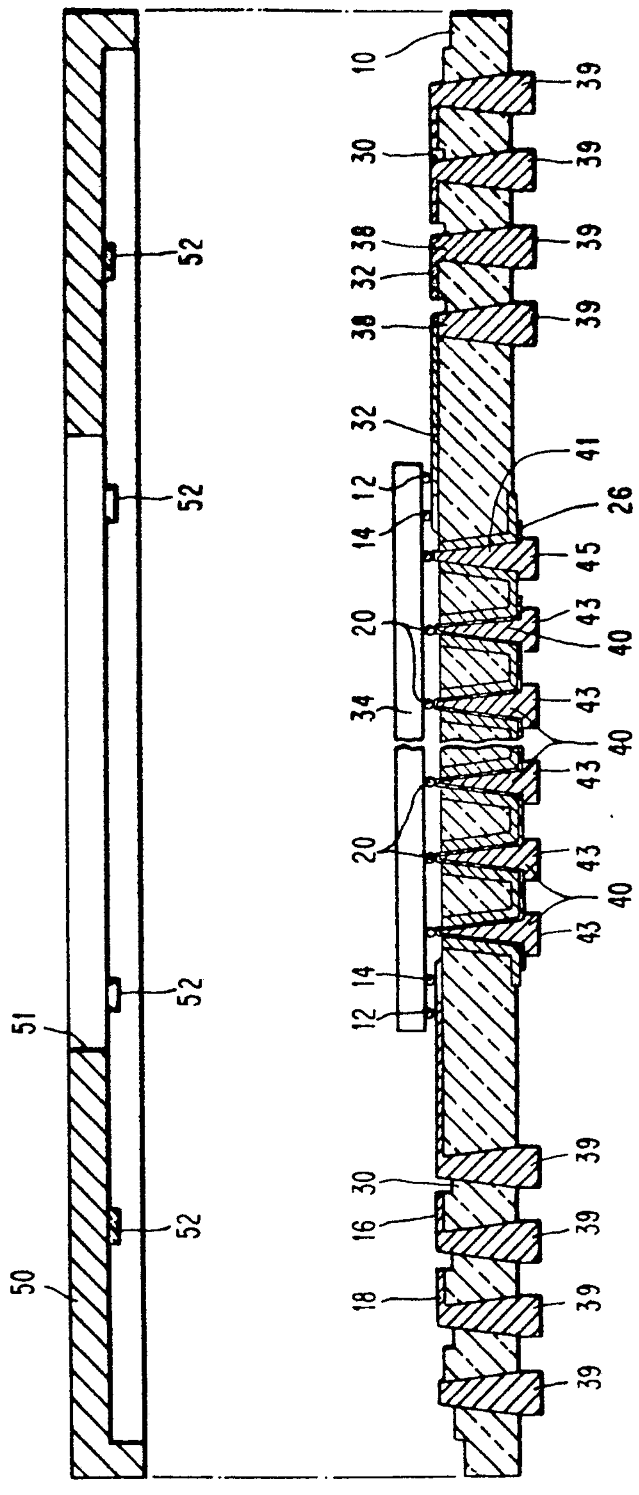
10
30
32 38
38
32
12
14
20
34
20
14
12
30
16
18
39
41
26
45
43
40
50
51
52

FIG. 7

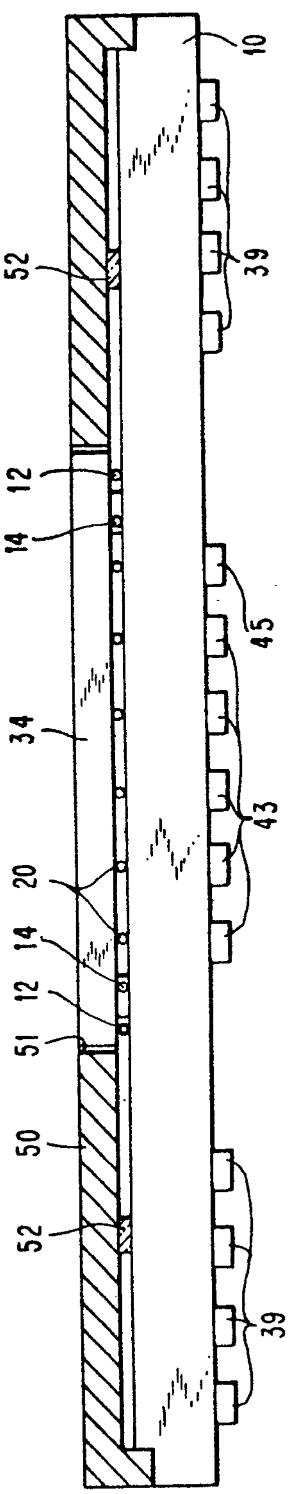
10
39
52
12
14
45
34
43
20
14
12
51
50
52
39

FIG.8

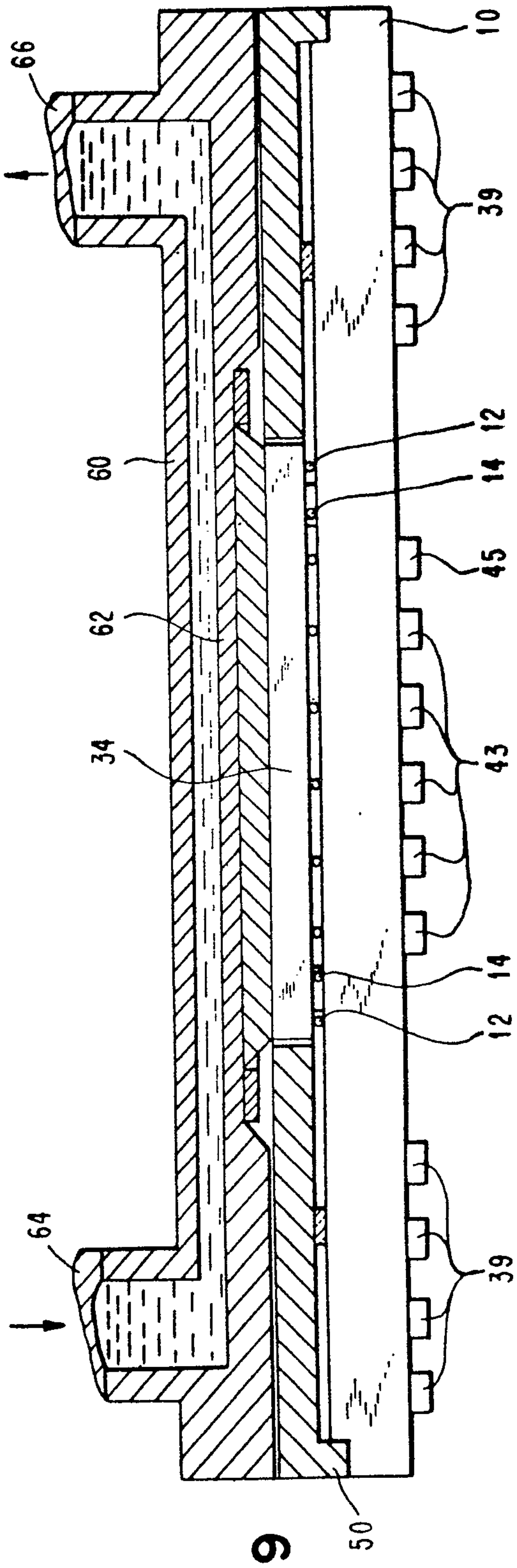
66
10
39
60
12
14
45
62
34
43
14
12
64
39
50

FIG.9

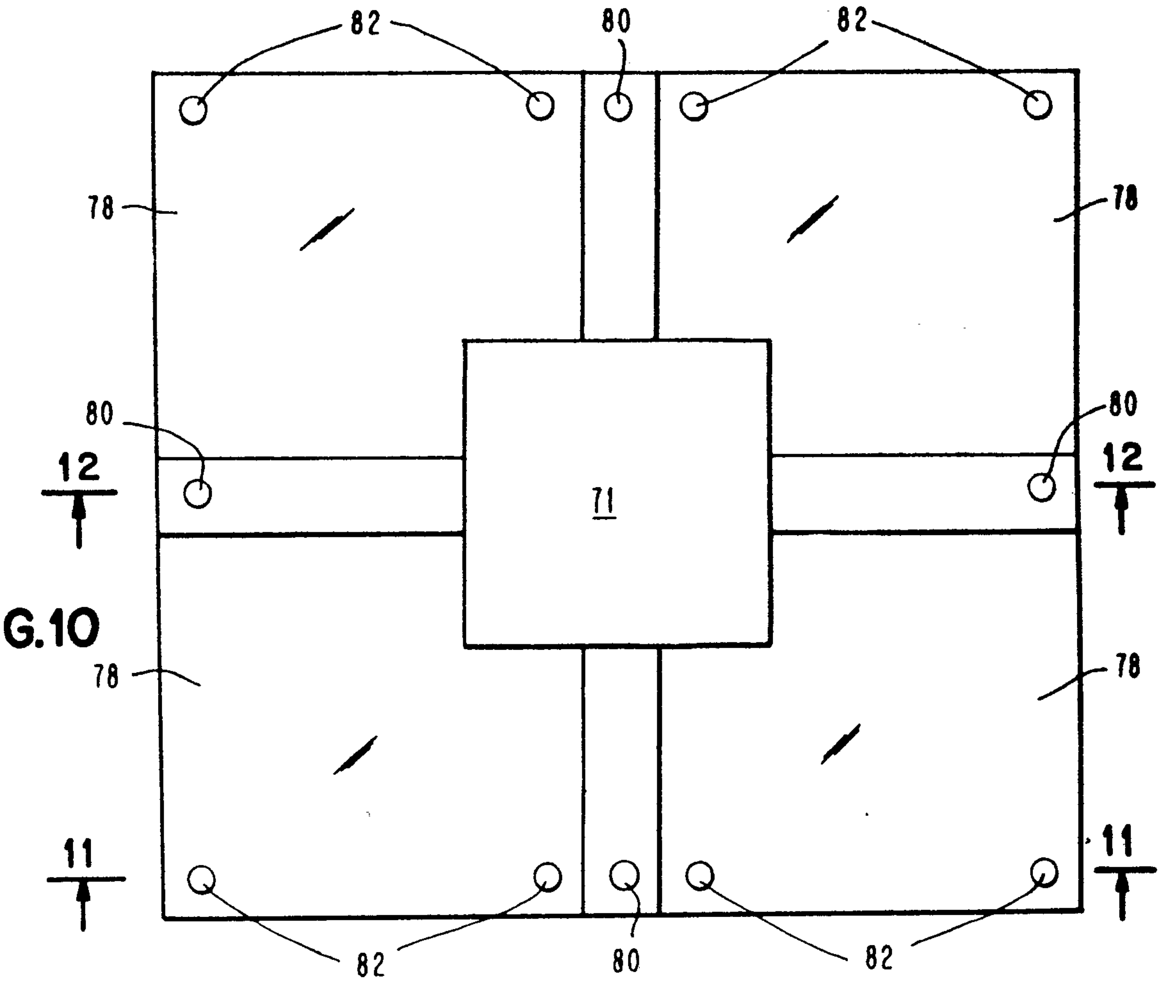


FIG.10

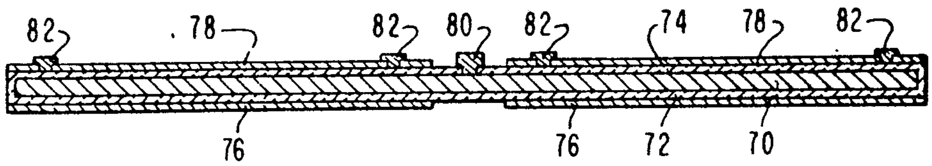


FIG.11

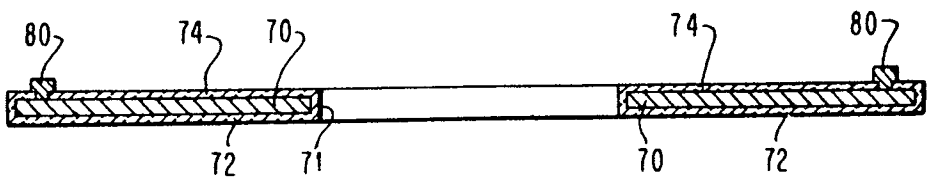


FIG.12